# EUROPÄISCHE PATENTSCHRIFT

(11) **EP 2 378 552 B1**
(45) Veröffentlichungstag und Bekanntmachung des Hinweises auf die Patenterteilung: **16.09.2015**
(21) Anmeldenummer: 11151487.3
(22) Anmeldetag: 20.01.2011
(51) Int. Cl.: H01L 23/00, H01L 23/48, H01L 25/07, H01R 12/52, H01R 12/57, H01R 13/24

(54) **Leistungshalbleitermodul mit Anschlusselementen**
Power semiconductor module with connection elements
Module semi-conducteur de puissance doté d'éléments de raccordement

(30) Priorität: 14.04.2010 DE 102010014940
(43) Veröffentlichungstag der Anmeldung: 19.10.2011
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- EP-A2- 1 601 016
- WO-A1-02/07265
- KR-A- 20100 022 720
- US-A- 5 791 911
- US-A1- 2004 252 477

## Beschreibung

Die Erfindung betrifft ein Leistungshalbleitermodul mit einer Mehrzahl von Anschlusselementen, insbesondere für Steuer-, Last- und Hilfsanschlüssen, für eine elektrisch leitende Verbindung, die von einem Substrat nach außen reichen. Einen Ausgangspunkt der Erfindung bilden Leistungshalbleitermodule wie sie beispielhaft aus der DE 10 2005 058 692 A1 bekannt sind.

Derartige Leistungshalbleitermodule bestehen nach dem Stand der Technik aus einem Gehäuse mit mindestens einer dazu angeordneten Grundplatte mit hierauf angeordneten Substraten. Weiterhin weisen die bekannten Leistungshalbleitermodule Anschlusselemente für externe Last- und Hilfsanschlüsse sowie im Inneren angeordnete Verbindungselemente auf. Auf den Substraten sind Leiterbahnen angeordnet, die als Kontaktfläche für die Anschlusselemente dienen. Die Verbindungselemente für schaltungsgerechte Verbindungen im Inneren des Leistungshalbleitermoduls sind meist als Drahtbondverbindungen ausgebildet. Des Weiteren wird ein Gehäuse offenbart, das eine Mehrzahl an Ausnehmungen als Halteeinrichtung für die Anschlusselemente aufweist.

Aus der EP 1 391 966 A1 ist ein Leistungshalbleitermodul mit einer Ausbildung von Anschlusselementen bekannt, welche jeweils einen Kontakt zu einem Leistungshalbleiterbauelement und einer externen Anschlussstelle bilden. Das Anschlusselement weist zwei Kontakteinrichtungen sowie einen federnden Abschnitt auf. Der federnde Abschnitt ist vorzugsweise spiralförmig ausgebildet und bildet somit einen Komprimierbereich für ein dynamisches und reversibles Kontaktverhalten des Anschlusselementes.

Nachteilig an den bekannten Ausgestaltungen ist die Anordnung der oben genannten Anschlusselemente im Gehäuse. Diese sind beabstandet voneinander in dem Gehäuse angeordnet, wodurch sich ein entsprechender lateraler Platzbedarf zur Kontaktierung des Substrats ergibt. Dies erweist sich dahingehend als problematisch, als der vorhandene Raum auf dem Substrat einerseits durch Drahibondverbindungen, andererseits vor allem durch die Leistungshalbleiterbauelemente eingenommen wird. Ein weiterer Nachteil der Anschlusselemente kann sich durch deren federnde Abschnitte ergeben, wenn diese wie aus mechanischer Sicht bevorzugt als Schraubenfeder ausgebildet sind. Wird die Schraubenfeder von einem sich ändernden Strom durchflossen wirkt diese physikalisch betrachtet als Spule. Dieser Stromfluss führt auf Grund von Induktion zu störenden Stromverläufen und damit möglicherweise zur Beeinträchtigung der Signalübertragung. Die beschriebene Ausführung der Anschlusselemente hat den weiteren Nachteil, dass bei Kontaktausfall ein weiterer Betrieb des Leistungshalbleitermoduls möglicherweise nicht mehr gegeben ist.

Aus der EP 1 601 016 A2 ist eine Anordnung in Schraub- Druckkontaktierung mit einer Leiterplatte und einem Leistungshalbleitermodul bekannt, wobei die Leiterplatte ein isolierendes Substrat mit darauf angeordneten Leiterbahnen aufweist, und das Leistungshalbleitermodul ein rahmenartiges isolierendes Kunststoffgehäuse, mindestens ein hierin angeordnetes Substrat mit mindestens einer Leiterbahn und mindestens einem hierauf angeordneten und schaltungsgerecht verbundenen Leistungshalbleiterbauelement, sowie Leistungsanschlüsse und Hilfsanschlüsse aufweist.

Aus der KR 2010 002 272 0 A sind koaxial angeordnete Kontaktelemente zur Kontaktierung von Leiterplatten bekannt.

Aus der US 5 791 911 A ist eine koaxial aufgebaute Verbindungeinrichtung zur Verbindung einer Elektronik mit einem PC Karte bekannt.

Der vorliegenden Erfindung liegt die Aufgabe zugrunde ein Leistungshalbleitermodul mit einer Mehrzahl von Anschlusselementen vorzustellen, welche eine kompakte Gestaltung des Leistungshalbleitermoduls ermöglichen, Einflüsse der Induktivitäten bei Stromflussänderungen verringern oder eine kompakte Ausgestaltung einer redundanten Ausführung der Anschlusselemente ermöglichen.

Die Aufgabe wird erfindungsgemäß gelöst durch Anschlusselemente nach dem Anspruch 1, spezielle Ausgestaltungen finden sich in den abhängigen Ansprüchen.

Der erfinderische Gedanke geht aus von einem Leistungshalbleitermodul der oben genannten Art vorzugsweise mit einer Grundplatte und einem Gehäuse, welches eines oder eine Mehrzahi von Substraten umschließt. Die erfindungsgemäße Ausgestaltung ist allerdings bei grundplattenlosen Leistungshalbleitermodulen ebenso vorteilhaft. Das Substrat seinerseits besteht aus einem Isolierstoffkörper mit einer Mehrzahl auf seiner ersten Hauptfläche befindlicher gegeneinander isolierter metallischer Leiterbahnen sowie vorzugsweise aus einer auf seiner zweiten Hauptfläche angeordneten flächigen metallischen Schicht. Des Weiteren weist das Substrat im Folgenden hierunter subsumierte Leistungshalbleiterbauelemente auf, die auf den Leiterbahnen angeordnet sind. Somit fallen unter den Begriff Kontaktflächen des Substrats auch Kontaktflächen eines Leistungshalbleiterbauelements.

Das erfindungsgemäße Leistungshalbleitermodul umfasst mindestens zwei Anschlusselemente, die jeweils einen elektrisch leitenden Kontakt mit dem Substrat aufweisen, wobei das erste Anschlusselement von dem zweiten Anschlusselement zumindest teilweise umschlossen wird. Die Anschlusselemente ihrerseits weisen jeweils einen zweiten Kontaktabschnitt zur Kontaktierung mit dem Substrat, und dort mit Leiterbahnen oder mit Kontaktflächen der Leistungshalbleiterbauelementen, einen ersten Kontaktabschnitt zur externen Verbindung, sowie einen dazwischen angeordneten federnden Abschnitt auf. Der federnde Abschnitt des zweiten Anschlusselementes und vorzugsweise auch derjenige federnde Abschnitt des ersten Anschlusselementes sind hierbei als Schraubenfedern ausgebildet. Es ist weiterhin bevorzugt, wenn das erste Anschlusselement zum zweiten Anschlusselement konzentrisch angeordnet ist. Eine exzentrische Anordnung kann allerdings in bestimmten Anwendungsfällen ebenfalls sinnvoll sein.

Durch die Ausbildung mittels zweier Anschlusselement kann eine redundante Ausbildung eines einzigen Steuer-, Last- oder Hilfsanschlusses ausgeführt sein. Hierzu sind das erste und das zweite Anschlusselement mit dem gleichen Potential des Substrates verbunden. Bei dieser redundanten Ausführung kann somit bei Kontakt- oder sonstigem Ausfall eines Anschlusselementes das zweite Anschlusselement dessen Funktion alleine übernehmen und einen Ausfall des Leistungshalbleitermoduls vermeiden.

Der erste und der zweite Kontaktabschnitt der jeweiligen Anschlusselemente sind vorzugsweise stiftartig ausgebildet. Ebenso ist es bevorzugt, wenn die ersten Kontaktabschnitte aus dem Gehäuse herausragen. Die zweiten Kontaktabschnitte sind zu dem Substrat angeordnet und bei Druckbeaufschlagung auf die Anschlusselemente elektrisch leitend hiermit verbunden. Weiterhin können die Kontaktabschnitte des ersten Anschlusselementes konzentrisch zu seinem federnden Abschnitt angeordnet sein. Dagegen sind die beide Kontaktabschnitte des zweiten Anschlusselementes vorzugsweise tangential oder annähernd tangential zu den Windungen des federnden Abschnittes angeordnet.

Das Gehäuse dient als Halteeinrichtung für die Anschlusselemente und weist hierfür jeweils den Anschlusselementen zugeordnet Ausnehmungen auf. Es liegen dabei eine erste zylinderartige und eine zweite hohlzylinderartige Ausnehmung vor, wobei die erste Ausnehmung zur zweiten Ausnehmung konzentrisch oder exzentrisch angeordnet sein kann. Das erste Anschlusselement wird in der ersten Ausnehmung und das zweite Anschlusselement in der zweiten Ausnehmung angeordnet. Die beiden Ausnehmungen werden mittels einer Isolierstoffhülse, die Teil des Gehäuses ist, elektrisch und mechanisch voneinander getrennt.

Die erfinderische Lösung wird anhand der Ausführungsbeispiele der Fig. 1 bis Fig. 4 näher erläutert.

Fig. 1 zeigt schematisch einen Schnitt durch ein erfindungsgemäßes Leistungshalbleitermodul.

Fig. 2 zeigt zwei Anschlusselemente eines ersten erfindungsgemäßen Leistungshalbleitermoduls in dreidimensionaler Darstellung.

Fig. 3 zeigt einen Schnitt durch eine Ausgestaltung gemäß Fig. 2.

Fig. 4 zeigt zwei Anschlusselemente eines zweiten erfindungsgemäßen Leistungshalbleitermoduls.

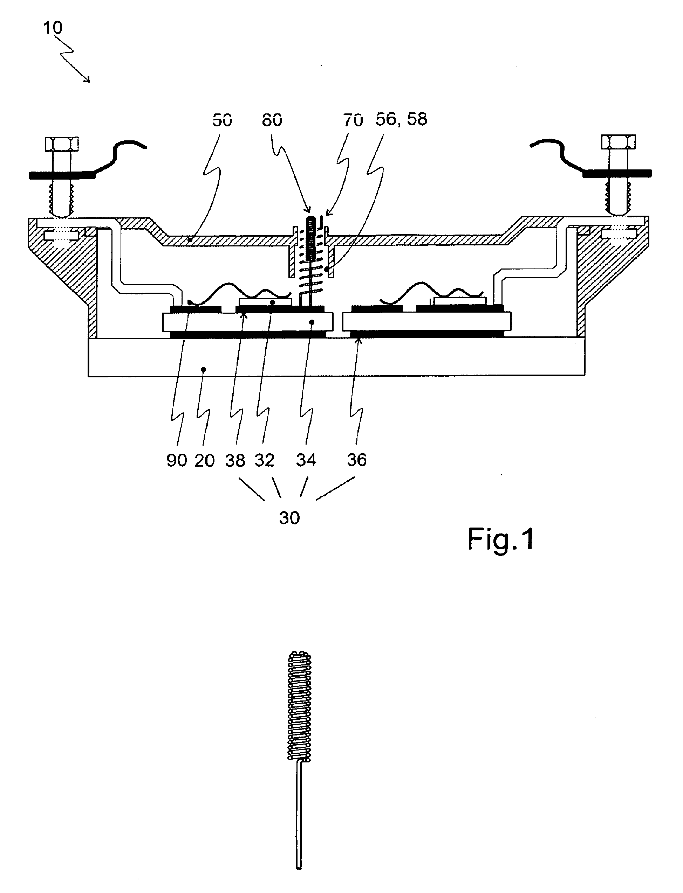

Fig. 1 zeigt schematisch ein erfindungsgemäßes Leistungshalbleitermodul (10), welches eine Grundplatte (20) mit hierauf angeordneten Substraten (30) aufweist. Das jeweilige Substrat (30) besteht aus einem Isolierstoffkörper (34) mit einer Mehrzahl auf seiner ersten Hauptfläche befindlicher gegeneinander isolierter metallischer Leiterbahnen (38) sowie vorzugsweise aus einer auf seiner zweiten Hauptfläche angeordneten flächigen metallischen Schicht (36). Des Weiteren weist hier das Substrat (30) Leistungshalbleiterbauelemente (32) auf, die auf den Leiterbahnen (38) angeordnet sind. Mittels Drahtbondverbindungen (90) sind die Leistungshalbleiterbauelemente mit den Leiterbahnen (38) verbunden.

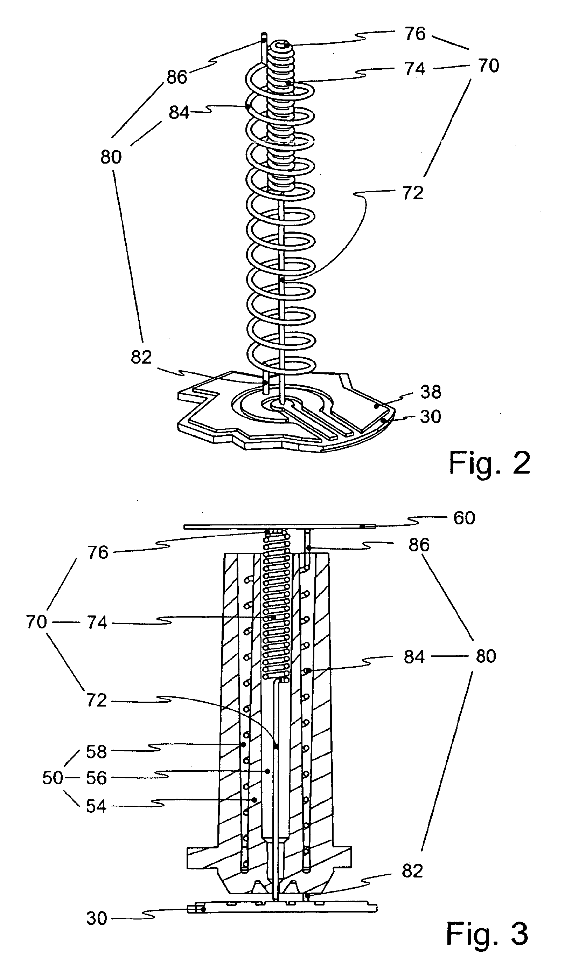

Weiterhin ist ein Gehäuse (50) dargestellt, welches die Mehrzahl von Substraten (30) umschließt. Das Gehäuse (50) weist weiterhin eine Mehrzahl von Ausnehmungen (56, 58) zur Durchführungen der Anschlusselemente (70, 80) zur externen Verbindung beispielhaft mit einer Leiterplatte auf (vgl. Fig. 3). Beide Anschlusselemente kontaktieren hier die gleiche Kontaktfläche des Substrats, wodurch sich eine redundante Ausbildung eines Gate- oder Hilfsanschlusses ergibt.

Bei weitere Ausgestaltungen eines Leistungshalbleitermoduls (10), beispielhaft ohne Grundplatte und / oder mit nur einem Substrat erweise sich die beschriebene Ausbildung der Anschlusselemente selbstverständlich ebenso als vorteilhaft.

Fig. 2 zeigt schematisch ein erstes und ein zweites Anschlusselement (70, 80) eines erfindungsgemäßen Leistungshalbleitermoduls (10) mit grundsätzlich gleichem Aufbau wie unter Fig. 1 dargestellt, wobei allerdings hier das erste Anschlusselement (70) als Gate- und das zweite Anschlusselement (80) als Hilfsemitteranschluss dient. Die Anschlusselemente (70, 80) weisen jeweils einen ersten Kontaktabschnitt (76, 86), einen zweiten Kontaktabschnitt (72, 82) und einen dazwischen angeordneten federnden Abschnitt (74, 84) auf. Die federnden Abschnitte (74, 84) der Anschlusselemente (70, 80) sind spiralförmig ausgebildet. Somit ist eine dynamische und reversible Bewegung und hierdurch bei Druckbeaufschlagung ein sicherer Kontakt der Kontaktabschnitte zu ihren Verbindungspartnern gewährleistet. Erfindungsgemäß umschließt der federnde Abschnitt (84) des zweiten Anschlusselementes (80), hier annährend vollständig, den federnden Abschnitt (74) des ersten Anschlusselementes (70). Das erste Anschlusselement (70) ist zu dem zweiten Anschlusselement (80) konzentrisch angeordnet. Die ersten (76, 86) und zweiten Kontaktabschnitte (72, 82) sind jeweils stiftartig ausgebildet. Weiterhin dargestellt ist ein Substrat (30) mit hierauf angeordneten Leiterbahnen (38), zu dem die Anschlusselemente (70, 80) angeordnet sind. Das erste Anschlusselement (70) ist mit seinem zweiten Kontaktabschnitt (72) mit einer ersten Leiterbahn, mit einem Gatepotential, verbunden, während das zweite Anschlusselement (80) mit seinem zweiten Kontaktabschnitt (82) mit einer zweiten Leiterbahn, mit einem Hilfsemitterpotential, verbunden ist.

Fig. 3 zeigt in einer Teilansicht einen Schnitt durch die Ausgestaltung des erfindungsgemäßen Leistungshalbleitermoduls gemäß Fig. 2, wobei zusätzlich ein Teil des Gehäuse (50) dargestellt ist, welches mit je einer Ausnehmung für eine Anordnung der Anschlusselemente (70, 80) versehen ist. Die erste Ausnehmung (56) ist zylindrisch ausgebildet und für das erste Anschlusselement (70) vorgesehen. Die zweite Ausnehmung (58) ist hohlzylindrisch ausgebildet und das zweite Anschlusselement (80) hierin angeordnet. Die erste Ausnehmung (56) liegt zu der zweiten Ausnehmung (58) konzentrisch und beide Ausnehmungen (56, 58) sind mittels einer Isolierstoffhülse (54), die vorteilhafterweise aus dem Gehäuse selbst ausgebildet ist, voneinander getrennt. Die Isolierstoffhülse (54) verhindert einen mechanische und elektrischen Kontakt der beiden Anschlusselemente (70, 80), so dass ein Kurzschluss und folglich eine mögliche Zerstörung des Leistungshalbleitermoduls vermieden wird.

Die Kontaktabschnitte (72, 76) des ersten Anschlusselementes (70) sind konzentrisch zum federnden Abschnitt (74) angeordnet. Dagegen verlaufen beide Kontaktabschnitte (82, 86) des zweiten Anschlusselementes (80) tangential oder annähernd tangential zu den Windungen dessen federnden Abschnittes.

Weiterhin dargestellt ist eine Leiterplatte (60), die parallel zu dem Substrat (30) außerhalb, oder in bestimmten Anwendungen auch innerhalb der Leistungshalbleitermoduls, angeordnet werden kann und der die ersten Kontaktabschnitte (76, 86) der Anschlusselemente (70, 80) zugeordnet sind. Die ersten Kontaktabschnitte (76, 86) der Anschlusselemente (70, 80) sind hier flächig ausgebildet, so dass ein flächiger Kontakt zu der Leiterplatte vorliegt.

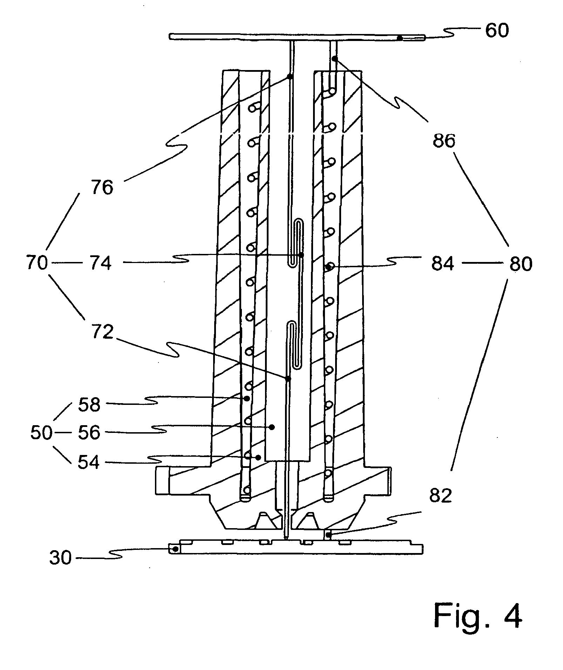

Fig. 4 zeigt in Teilansicht einen Schnitt durch eine zweite Ausgestaltung des erfindungsgemäßen Leistungshalbleitermoduls mit Anschlusselementen und Gehäuse. Das erste Anschlusselement (70) weist einen ersten Kontaktabschnitt (76), einen zweiten Kontaktabschnitt (72) und einen federnden Abschnitt (74) auf, wobei der federnde Abschnitt (74) als Metallband ausgebildet ist und mittels einer gegenläufigen Doppelbiegung zu dem ersten und zweiten Kontaktabschnitt (72, 76) verbunden ist. Das zweite Anschlusselement (80) ist als Schraubenfeder ausgebildet und weist einen ersten Kontaktabschnitt (86), einen zweiten Kontaktabschnitt (82) und einen federnden Abschnitt (84) auf. Der federnde Abschnitt (84) des zweiten Anschlusselementes (80) umschließt zumindest teilweise den federnden Abschnitt (74) des ersten Anschlusselementes.

### Bezugszeichenliste

- 10: Leistungshalbleitermodul
- 20: Grundplatte
- 70, 80: Anschlusselemente
- 76, 86: Erste Kontaktabschnitte
- 72, 82: Zweite Kontaktabschnitte
- 74, 84: Federnder Abschnitt
- 30: Substrat
- 32: Leistungshalbleiterbauelement
- 34: Isolierstoffkörper
- 36: Metallische Schicht
- 38: Leiterbahn
- 50: Gehäuse
- 56, 58: Ausnehmungen
- 54: Isolierstoffhülse
- 60: Leiterplatte
- 90: Drahtbondverbindung

## Patentansprüche

1. Leistungshalbleitermodul mit einem Gehäuse (50),
mit mindestens einem Substrat (30), hierauf schaltungsgerecht angeordneten Leiterbahnen (38) und mindestens einem Leistungshalbleiterbauelement (32), mit mindestens einem ersten und einem zweiten Anschlusselement (70, 80), die jeweils einen ersten Kontaktabschnitt (76, 86), einen zweiten Kontaktabschnitt (72, 82) und einen dazwischen angeordneten federnden Abschnitt (74, 84) aufweisen,
wobei jeweils die zweiten Kontaktabschnitte (72, 82) der ersten und zweiten Anschlusselemente (70, 80) einen elektrisch leitenden Kontakt mit dem Substrat (30) aufweisen,
das Gehäuse (50) zur Anordnung der Anschlusselemente (70, 80) Ausnehmungen (56, 58) aufweist, **dadurch gekennzeichnet, dass**
der federnde Abschnitt (84) des zweiten Anschlusselementes (80) als Schraubenfeder ausgebildet ist und das erste Anschlusselement (70) zumindest teilweise umschließt, wobei das erste Anschlusselement (70) in einer ersten zylinderartigen Ausnehmung (56) des Gehäuses (50) angeordnet ist und das zweite Anschlusselement (80) in einer zweiten hohlzylinderartigen Ausnehmung (58) des Gehäuses (50) angeordnet ist, wobei die beiden Ausnehmungen (56, 58) mittels einer Isolierstoffhülse (54) voneinander getrennt sind.

2. Leistungshalbleitermodul nach Anspruch 1, wobei
das erste Anschlusselement (70) konzentrisch oder exzentrisch zum zweiten Anschlusselement (80) angeordnet ist.

3. Leistungshalbleitermodul nach Anspruch 1, wobei
der erste Kontaktabschnitt (76, 86) des ersten und zweiten Anschlusselementes (70, 80) aus dem Gehäuse (50) des Leistungshalbleitermoduls herausragt.

4. Leistungshalbleitermodul nach Anspruch 1, wobei
eine Leiterplatte (60) parallel zu dem Substrat (30) derart anordenbar ist, dass die zweiten Kontaktabschnitte (72, 82) mit dieser elektrisch leitend verbindbar sind und durch diese Anordnung der Leiterplatte die Anschlusselemente (70, 80) mit Druck beaufschlagt werden.

5. Leistungshalbleitermodul nach Anspruch 1, wobei
die erste Ausnehmung (56) des Gehäuses (50) konzentrisch zu der zweiten Ausnehmung (58) des Gehäuses (50) angeordnet ist.

6. Leistungshalbleitermodul nach Anspruch 1, wobei
der erste (76 86) und der zweite Kontaktabschnitt (72, 82) des jeweiligen Anschlusselements (70, 80) stiftartig ausgebildet sind.

7. Leistungshalbleitermodul nach Anspruch 1, wobei
der erste (76) und der zweite Kontaktabschnitt (72) des ersten Anschlusselementes (70) konzentrisch zu dem federnden Abschnitt (74) angeordnet sind.

8. Leistungshalbleitermodul nach Anspruch 1, wobei
die Kontaktabschnitte (82, 86) des zweiten Anschlusselementes (80) tangential oder annähernd tangential zu den Windungen des federnden Abschnittes (84) angeordnet sind.

## Claims

1. Power semiconductor module comprising a housing (50),
comprising at least one substrate (30), conductor tracks (38) arranged thereon in a circuit-conforming manner, and at least one power semiconductor component (32), comprising at least one first and one second connection element (70, 80), each having a first contact section (76, 86), a second contact section (72, 82) and a resilient section (74, 84) arranged there-between,
wherein the second contact sections (72, 82) of the first and second connection elements (70, 80) in each case have an electrically conductive contact with the substrate (30),
the housing (50) for arrangement of the connection elements (70, 80) has cutouts (56, 58), **characterized in that**
the resilient section (84) of the second connection element (80) is embodied as a helical spring and at least partly encloses the first connection element (70), wherein the first connection element (70) is arranged in a first cylinder-like cutout (56) of the housing (50) and the second connection element (80) is arranged in a second hollow-cylinder-like cutout (58) of the housing (50), wherein the two cutouts (56, 58) are separated from one another by means of an insulating material sleeve (54).

2. Power semiconductor module according to Claim 1, wherein the first connection element (70) is arranged concentrically or eccentrically with respect to the second connection element (80).

3. Power semiconductor module according to Claim 1, wherein
the first contact section (76, 86) of the first and second connection elements (70, 80) projects from the housing (50) of the power semiconductor module.

4. Power semiconductor module according to Claim 1, wherein
a printed circuit board (60) can be arranged parallel to the substrate (30) in such a way that the second contact sections (72, 82) can be electrically conductively connected to said printed circuit board and pressure is applied to the connection elements (70, 80) by this arrangement of the printed circuit board.

5. Power semiconductor module according to Claim 1, wherein
the first cutout (56) of the housing (50) is arranged concentrically with respect to the second cutout (58) of the housing (50).

6. Power semiconductor module according to Claim 1, wherein
the first contact section (76, 86) and the second contact section (72, 82) of the respective connection elements (70, 80) are embodied in pin-like fashion.

7. Power semiconductor module according to Claim 1, wherein
the first contact section (76) and the second contact section (72) of the first connection element (70) are arranged concentrically with respect to the resilient section (74).

8. Power semiconductor module according to Claim 1, wherein
the contact sections (82, 86) of the second connection element (80) are arranged tangentially or approximately tangentially with respect to the turns of the resilient section (84).

## Revendications

1. Module semi-conducteur de puissance avec un boîtier (50), avec au moins un substrat (30), des pistes conductrices (38) disposées dessus de manière conforme aux circuits, et au moins un composant semi-conducteur de puissance (32), avec au moins un premier et un deuxième élément de connexion (70, 80) qui présentent respectivement une première partie de contact (76, 86), une deuxième partie de contact (72, 82) et une partie élastique (74, 84) située entre, dans lequel respectivement les deuxièmes parties de contact (72, 82) des premier et deuxième éléments de connexion (70, 80) présentent un contact électroconducteur avec le substrat (30),
le boîtier (50) présente des évidements (56, 58) pour la disposition des éléments de connexion (70, 80),
**caractérisé en ce que** la partie élastique (84) du deuxième élément de connexion (80) est réalisée en tant que ressort à boudin et entoure au moins partiellement le premier élément de connexion (70), dans lequel le premier élément de connexion (70) est disposé dans un premier évidement (56) semblable à un cylindre du boîtier (50) et le deuxième élément de connexion (80) est disposé dans un deuxième évidement (58) semblable à un cylindre creux du boîtier (50), dans lequel les deux évidements (56, 58) sont séparés l'un de l'autre au moyen d'une gaine de matière isolante (54).

2. Module semi-conducteur de puissance selon la revendication 1, dans lequel le premier élément de connexion (70) est disposé de manière concentrique ou excentrique au deuxième élément de connexion (80).

3. Module semi-conducteur de puissance selon la revendication 1, dans lequel la première partie de contact (76, 86) des premier et deuxième éléments de connexion (70, 80) dépasse du boîtier (50) du module semi-conducteur de puissance.

4. Module semi-conducteur de puissance selon la revendication 1, dans lequel une carte de circuits imprimés (60) peut être disposée parallèlement au substrat (30) de manière à ce que les deuxièmes parties de contact (72, 82) puissent être reliées de manière électroconductrice à celle-ci et que grâce à cette disposition de la carte de circuits imprimés, les éléments de connexion (70, 80) soient soumis à l'application d'une pression.

5. Module semi-conducteur de puissance selon la revendication 1, dans lequel le premier évidement (56) du boîtier (50) est disposé de manière concentrique par rapport au deuxième évidement (58) du boîtier (50).

6. Module semi-conducteur de puissance selon la revendication 1, dans lequel la première (76, 86) et la deuxième partie de contact (72, 82) de l'élément de connexion (70, 80) respectif sont réalisées à la manière d'une tige.

7. Module semi-conducteur de puissance selon la revendication 1, dans lequel la première (76) et la deuxième partie de contact (72) du premier élément de connexion (70) sont disposées de manière concentrique à la partie élastique (74).

8. Module semi-conducteur de puissance selon la revendication 1, dans lequel les parties de contact (82, 86) du deuxième élément de connexion (80) sont disposées de manière tangentielle ou approximativement tangentielle aux spires de la partie élastique (84).
